# EUROPEAN PATENT APPLICATION

(11) **EP 4 745 277 A1**
(43) Date of publication of application: **20.05.2026**
(21) Application number: 24853302.8
(22) Date of filing: 27.05.2024
(51) Int. Cl.: C25D 5/44, C25D 5/30, C23C 28/02, C25D 5/10, C25D 5/12, C25D 3/12, C25D 3/48

(54) **ALUMINUM-BASED COMPOSITE MATERIAL AND PREPARATION METHOD THEREFOR, AND ELECTRONIC DEVICE**

(30) Priority: 11.08.2023 CN 202311021148
(71) Applicant: Huawei Technologies Co., Ltd., Shenzhen, Guangdong 518129 (CN)
(72) Inventor: LI, Xiaoyue, Shenzhen, Guangdong 518129 (CN); REN, Chang You, Shenzhen, Guangdong 518129 (CN); HAN, Zuoyan, Shenzhen, Guangdong 518129 (CN)
(74) Representative: Isarpatent
(86) International application number: PCT/CN2024/095440
(87) International publication number: WO 2025/035887

(57) **Abstract**

This application pertains to the field of electrical materials, and discloses an aluminum matrix composite material and a preparation method therefor, and an electronic device. The preparation method includes: performing purification processing on an aluminum-based substrate to obtain a purified aluminum-based substrate; forming a metal protective layer on a surface of the purified aluminum-based substrate to obtain a first composite material intermediate; performing first electroplating processing on the first composite material intermediate, so that the metal protective layer is corroded to form a first metal plating layer on the surface of the aluminum-based substrate and obtain a second composite material intermediate; and performing second electroplating processing on the second composite material intermediate to form a second metal plating layer on a surface of the first metal plating layer and obtain the aluminum matrix composite material. The preparation method can improve compactness and flatness of the plating layers. In addition, the preparation method eliminates a need to introduce another inert precious metal in the preparation process, and achieves advantages such as a simplified operation procedure, convenience, high efficiency, high reliability, and low costs.

## Description

This application claims priority to Chinese Patent Application No. 202311021148.9, filed on August 11, 2023 and entitled "ALUMINUM MATRIX COMPOSITE MATERIAL AND PREPARATION METHOD THEREFOR, AND ELECTRONIC DEVICE", which is incorporated herein by reference in its entirety.

### TECHNICAL FIELD

The present disclosure relates to the field of electrical materials, and in particular, to an aluminum matrix composite material and a preparation method therefor, and an electronic device.

### BACKGROUND

Due to advantages such as high thermal conductivity, adjustable coefficient of thermal expansion, low density, high dimensional stability, and excellent electrical performance, aluminum-based materials are widely used for fabrication of printed circuit boards, circuit package structures, and the like. To achieve solderability of the aluminum-based material and improve physicochemical properties (for example, reduce porosity and enhance corrosion resistance) of the aluminum-based material, currently, electroless nickel immersion gold (Electroless Nickel Immersion Gold, ENIG) is usually used to form a nickel plating layer and a gold plating layer on a surface of the aluminum-based material.

At present, electroless nickel immersion gold has the following problem: The electroless nickel plating layer is prone to dissolving and corroding the electroless gold plating layer. This not only leads to "black pad syndrome", but also reduces surface wettability of the electroless gold plating layer, making it impossible to prepare an electrical interconnection structure on the electroless gold plating layer through a bonding process. In related technologies, either impurity atoms such as P or Cu are doped into the electroless nickel plating layer, or an inert Pd layer is disposed between the electroless nickel plating layer and the electroless gold plating layer, to improve corrosion resistance of the nickel plating layer.

However, an electroless plating layer prepared by using the related technologies exhibit poor flatness and low compactness, which compromises long-term stability of properties such as corrosion resistance and oxidation resistance of the plating layer.

### SUMMARY

In view of this, the present disclosure provides an aluminum matrix composite material and a preparation method therefor, and an electronic device, to resolve a technical problem in related technologies.

In one aspect, a preparation method for an aluminum matrix composite material is provided, where the preparation method for the aluminum matrix composite material includes:
performing purification processing on an aluminum-based substrate to obtain a purified aluminum-based substrate;
forming a metal protective layer on a surface of the purified aluminum-based substrate to obtain a first composite material intermediate;
performing first electroplating processing on the first composite material intermediate, so that the metal protective layer is corroded, to form a first metal plating layer on the surface of the aluminum-based substrate and obtain a second composite material intermediate; and
performing second electroplating processing on the second composite material intermediate to form a second metal plating layer on a surface of the first metal plating layer and obtain the aluminum matrix composite material.

According to the preparation method for the aluminum matrix composite material provided in this embodiment of the present disclosure, the metal protective layer is formed on the surface of the aluminum-based substrate, so that the metal protective layer can protect the aluminum-based substrate against formation of an oxide film on the surface of the aluminum-based substrate. During the first electroplating processing, the metal protective layer can be corroded as a sacrificial layer, and the first metal plating layer is adhered to the surface of the aluminum-based substrate in place of the metal protective layer. This not only helps enhance a bonding force between the first metal plating layer and the aluminum-based substrate, but also prevents the aluminum-based substrate from not being oxidized and corroded by an electroplating solution in the electroplating process. Because the aluminum-based substrate is relatively reactive, the aluminum-based substrate is highly susceptible to corrosion in the electroplating solution. However, application of the metal protective layer effectively addresses this problem. Further, the second electroplating processing is performed on the second composite material intermediate provided with the first metal plating layer, to form the second metal plating layer on the surface of the first metal plating layer and obtain the aluminum matrix composite material. In the aluminum matrix composite material, the aluminum-based substrate, the first metal plating layer, and the second metal plating layer are sequentially stacked. The first metal plating layer and the second metal plating layer are formed through an electroplating process. This makes the first metal plating layer and the second metal plating layer uniform and compact, avoiding element diffusion between the first metal plating layer and the second metal plating layer and helping improve stability of the plating layers. This also makes the surface of the first metal plating layer and a surface of the second metal plating layer flat. In conclusion, the preparation method for the aluminum matrix composite material provided in this embodiment of the present disclosure can improve compactness and flatness of the plating layers, thereby improving corrosion resistance and oxidation resistance of the plating layers. In addition, the preparation method for the aluminum matrix composite material eliminates a need to introduce another inert precious metal in the preparation process, and achieves advantages such as a simplified operation procedure, convenience, high efficiency, high reliability, and low costs.

In some possible implementations, the metal protective layer includes a zinc layer. The zinc layer can effectively protect the aluminum-based substrate, and exhibits a simple and reliable preparation process that does not cause damage to the aluminum-based substrate.

In some possible implementations, forming the metal protective layer on the surface of the purified aluminum-based substrate to obtain the first composite material intermediate includes:
placing the purified aluminum-based substrate in a zinc plating solution and performing zinc plating processing, to form the zinc layer on the surface of the purified aluminum-based substrate and obtain the first composite material intermediate, where
the zinc plating solution includes components in the following formulation:
50 g/L to 200 g/L of sodium hydroxide, 5 g/L to 50 g/L of potassium sodium tartrate, 1 g/L to 10 g/L of zinc oxide, 0.2 g/L to 2 g/L of iron and ferrous compounds, and water as balance, so that a pH value of the zinc plating solution ranges from 12 to 14.

The zinc layer is plated on the surface of the aluminum-based substrate through electroless plating, which is easy to operate and makes a thickness of the zinc layer controllable. The aluminum-based substrate is processed by using the foregoing zinc plating solution to remove an Al₂O₃ film and inhibit regeneration of the Al₂O₃ film, thereby exposing the aluminum-based surface of the aluminum-based substrate and bringing the aluminum-based surface to a desired pre-plating condition. In this way, the first metal plating layer can be grown on the surface of the aluminum-based substrate after the zinc layer is sacrificed.

In some possible implementations, a thickness of the metal protective layer ranges from 1 nm to 100 nm.

In some possible implementations, the first metal plating layer includes a nickel plating layer or a nickel-phosphorus alloy plating layer; and
the second metal plating layer includes a gold plating layer.

In this way, an aluminum matrix composite material with a nickel plating layer and a gold plating layer can be prepared. The nickel plating layer and the gold plating layer are formed through an electroplating process. This makes the nickel plating layer and the gold plating layer uniform, compact, and flat, so that the compact nickel plating layer and the compact gold plating layer avoid mutual diffusion of the nickel element and the gold element. Moreover, both the nickel plating layer and the gold plating layer are pure phases and free from other impurity elements, thereby avoiding a galvanic effect and eliminating a black pad problem. This improves stability of the nickel plating layer and the gold plating layer, thereby making corrosion resistance and oxidation resistance of the nickel plating layer and the gold plating layer more stable. In addition, surface flatness and uniformity of the plating layer facilitate soldering and gold wire bonding.

In some possible implementations, the first metal plating layer is a nickel plating layer, the first electroplating processing uses a nickel plating solution, and the nickel plating solution includes components in the following formulation: 1 g/L to 50 g/L of nickel sulfate, 1 g/L to 50 g/L of nickel chloride, 1 g/L to 50 g/L of nickel methanesulfonate, 1 g/L to 50 g/L of hydrochloric acid, 1 g/L to 10 g/L of a primary brightener, 0.1 g/L to 1 g/L of an auxiliary brightener, and water as balance. The nickel plating solution based on the foregoing formulation has advantages of stable chemical properties and a long service life.

In some possible implementations, during the first electroplating processing, a current density ranges from 0.1 ASD to 5 ASD, and an electroplating temperature ranges from 45°C to 65°C. Operation parameters of nickel electroplating are specified as above, achieving advantages of increasing a plating rate and making a plating film uniform in thickness.

In some possible implementations, the second metal plating layer is a gold plating layer, the second electroplating processing uses a gold plating solution, and the gold plating solution includes components in the following formulation: 10 g/L to 20 g/L of gold trichloride, 50 g/L to 130 g/L of sodium sulfite, 30 g/L to 50 g/L of ethylenediaminetetraacetic acid, 30 g/L to 50 g/L of citric acid, 50 g/L to 80 g/L of potassium chloride, and water as balance. The gold plating solution based on the foregoing formulation has advantages of increasing a plating rate and making a plating film uniform in thickness.

In some possible implementations, during the second electroplating processing, a current density ranges from 0.1 ASD to 5 ASD, and an electroplating temperature ranges from 30°C to 45°C. Operation parameters of gold electroplating are specified as above, achieving advantages of increasing a plating rate and making a plating film uniform in thickness.

In some possible implementations, the preparation method for the aluminum matrix composite material further includes: before performing the zinc plating processing on the purified aluminum-based substrate, performing surface etching processing on the purified aluminum-based substrate, so that a rough structure is formed on the surface of the purified aluminum-based substrate, where
the rough structure is configured to enhance a bonding force between the aluminum-based substrate and the first metal plating layer.

In some possible implementations, the purified aluminum-based substrate is placed in an etching solution to perform the surface etching processing; and
the etching solution includes components in the following formulation:
10 g/L to 50 g/L of tetramethylammonium hydroxide, 10 g/L to 50 g/L of disodium ethylenediaminetetraacetate, 5 g/L to 20 g/L of zinc oxide, 5 g/L to 20 g/L of barbituric acid, 0.1 g/L to 1 g/L of a soluble silver salt, and water as balance, so that a pH value of the etching solution ranges from 10 to 13.

In another aspect, an aluminum matrix composite material is provided, where the aluminum matrix composite material includes an aluminum-based substrate, a first metal plating layer, and a second metal plating layer that are sequentially stacked;
a cell diameter of the first metal plating layer is less than or equal to 100 nm; and
a cell diameter of the second metal plating layer is less than or equal to 100 nm.

In some possible implementations, a rough structure is provided on a surface that is of the aluminum-based substrate and on which the aluminum-based substrate and the first metal plating layer are bonded to each other, and the rough structure is configured to enhance a bonding force between the aluminum-based substrate and the first metal plating layer.

In still another aspect, an electronic device is provided, where the electronic device includes a device body and a pad structure connected to the device body, and the pad structure is prepared by using the aluminum matrix composite material according to any one of the foregoing implementations.

According to the aluminum matrix composite material provided in this embodiment of the present disclosure, a cell diameter of a nickel plating layer of the aluminum matrix composite material is less than or equal to 100 nm, and lattices in the nickel plating layer are compact, so that the nickel plating layer is uniform and compact. A cell diameter of a gold plating layer of the aluminum matrix composite material is less than or equal to 100 nm, and lattices in the gold plating layer are compact, so that the gold plating layer is uniform and compact, and provides excellent coverage for the nickel plating layer. The compact nickel plating layer and the compact gold plating layer avoid mutual diffusion of the nickel element and the gold element, thereby avoiding a galvanic effect and a black pad problem. This improves stability of the nickel plating layer and the gold plating layer, thereby making corrosion resistance and oxidation resistance of the nickel plating layer and the gold plating layer more stable. In addition, surface flatness and uniformity of the gold plating layer facilitate soldering and gold wire bonding.

In some possible implementations, the electronic device includes a chip and a printed circuit board.

### BRIEF DESCRIPTION OF DRAWINGS

FIG. 1 is an example flowchart of preparation of an aluminum matrix composite material according to an embodiment of the present disclosure;
FIG. 2 is another example flowchart of preparation of an aluminum matrix composite material according to an embodiment of the present disclosure;
FIG. 3 shows SEM images of a nickel plating layer of an aluminum matrix composite material according to Embodiment 1 at different magnifications;
FIG. 4 shows SEM images of a nickel plating layer of an aluminum matrix composite material according to Comparative Example 1 at different magnifications;
FIG. 5 shows SEM images of a gold plating layer of an aluminum matrix composite material according to Embodiment 1 at different magnifications; and
FIG. 6 shows SEM images of a gold plating layer of an aluminum matrix composite material according to Comparative Example 1 at different magnifications.

### DESCRIPTION OF EMBODIMENTS

The following clearly and completely describes technical solutions in embodiments of the present disclosure with reference to accompanying drawings. It is clear that the described embodiments are merely some rather than all of embodiments of the present disclosure. All other embodiments obtained by a person of ordinary skill in the art based on embodiments of the present disclosure without creative efforts shall fall within the protection scope of the present disclosure.

At present, electroless nickel immersion gold, also referred to as chemical Ni/Au, sequentially forms a nickel plating layer and a gold plating layer on a surface of an aluminum-based material through electroless plating. However, the nickel plating layer and the gold plating layer that are formed through electroless plating have relatively loose grains. This makes the nickel element and the gold element prone to mutual diffusion, leading to an electrochemical reaction between the nickel plating layer and the gold plating layer and resulting in "black pad syndrome". Therefore, it can be learned that stability of the nickel plating layer and the gold plating layer is poor. This also makes a surface of the plating layer not flat and non-uniform, reducing surface wettability of the gold plating layer. Consequently, solder paste and the like cannot naturally spread on the surface of the gold plating layer, which does not facilitate soldering; and it is impossible to form an electrical interconnection between a gold wire and the surface of the gold plating layer through a bonding process.

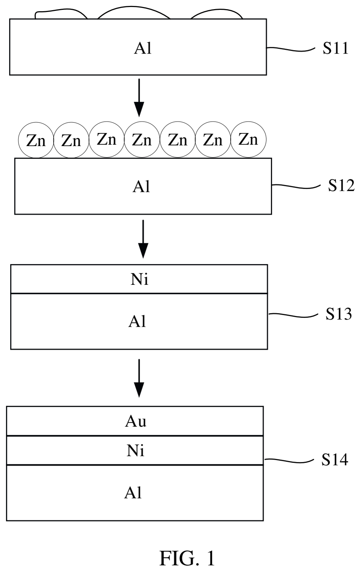

To address technical problems in related technologies, an embodiment of the present disclosure provides a preparation method for an aluminum matrix composite material. As shown in FIG. 1, the preparation method for the aluminum matrix composite material includes the following steps.

Step S11: Perform purification processing on an aluminum-based substrate to obtain a purified aluminum-based substrate.

Step S12: Form a metal protective layer on a surface of the purified aluminum-based substrate to obtain a first composite material intermediate.

Step S13: Perform first electroplating processing on the first composite material intermediate, so that the metal protective layer is corroded to form a first metal plating layer on the surface of the aluminum-based substrate and obtain a second composite material intermediate.

Step S14: Perform second electroplating processing on the second composite material intermediate to form a second metal plating layer on a surface of the first metal plating layer and obtain the aluminum matrix composite material.

According to the preparation method for the aluminum matrix composite material provided in this embodiment of the present disclosure, the metal protective layer is formed on the surface of the aluminum-based substrate, so that the metal protective layer can protect the aluminum-based substrate against formation of an oxide film on the surface of the aluminum-based substrate. During the first electroplating processing, the metal protective layer can be corroded as a sacrificial layer, and the first metal plating layer is adhered to the surface of the aluminum-based substrate in place of the metal protective layer. This not only helps enhance a bonding force between the first metal plating layer and the aluminum-based substrate, but also prevents the aluminum-based substrate from not being oxidized and corroded by an electroplating solution in the electroplating process. Because the aluminum-based substrate is relatively reactive, the aluminum-based substrate is highly susceptible to corrosion in the electroplating solution. However, application of the metal protective layer effectively addresses this problem. Further, the second electroplating processing is performed on the second composite material intermediate provided with the first metal plating layer, to form the second metal plating layer on the surface of the first metal plating layer and obtain the aluminum matrix composite material. In the aluminum matrix composite material, the aluminum-based substrate, the first metal plating layer, and the second metal plating layer are sequentially stacked. The first metal plating layer and the second metal plating layer are formed through an electroplating process. This makes the first metal plating layer and the second metal plating layer uniform and compact, avoiding element diffusion between the first metal plating layer and the second metal plating layer and helping improve stability of the plating layers. This also makes the surface of the first metal plating layer and a surface of the second metal plating layer flat.

In conclusion, the preparation method for the aluminum matrix composite material provided in this embodiment of the present disclosure can improve compactness and flatness of the plating layers, thereby improving corrosion resistance and oxidation resistance of the plating layers. In addition, the preparation method for the aluminum matrix composite material eliminates a need to introduce another inert precious metal in the preparation process, and achieves advantages such as a simplified operation procedure, convenience, high efficiency, high reliability, and low costs.

In some examples, the first metal plating layer includes a nickel plating layer or a nickel-phosphorus alloy plating layer; and the second metal plating layer includes a gold plating layer. For example, the first metal layer is a nickel plating layer, and the second metal plating layer is a gold plating layer, so that bonding of the aluminum-based substrate with nickel and gold is implemented to obtain an electroplated Ni-Au structure. As a result, the formed aluminum matrix composite material includes the aluminum-based substrate, the nickel plating layer, and the gold plating layer that are sequentially stacked, so that the aluminum matrix composite material can be used in a pad structure.

It can be learned that, according to the preparation method for the aluminum matrix composite material provided in this embodiment of the present disclosure, during the first electroplating processing, the metal protective layer can be corroded as a sacrificial layer, and the compact and flat nickel plating layer is adhered to the surface of the aluminum-based substrate in place of the metal protective layer. Gold electroplating is performed on the second composite material intermediate provided with the nickel plating layer, to continue to form the compact and flat gold plating layer on the surface of the compact and flat nickel plating layer and obtain the aluminum matrix composite material.

In the aluminum matrix composite material, the nickel plating layer and the gold plating layer are formed through an electroplating process. This makes the nickel plating layer and the gold plating layer uniform, compact, and flat, so that the compact nickel plating layer and the compact gold plating layer avoid mutual diffusion of the nickel element and the gold element. Moreover, both the nickel plating layer and the gold plating layer are pure phases and free from other impurity elements, thereby avoiding a galvanic effect and eliminating a black pad problem. This improves stability of the nickel plating layer and the gold plating layer, thereby making corrosion resistance and oxidation resistance of the nickel plating layer and the gold plating layer more stable. In addition, surface flatness and uniformity of the plating layer facilitate soldering and gold wire bonding.

The following describes in more detail each step related to the aluminum matrix composite material and a function of the step.

In step S11, purification processing is performed on the aluminum-based substrate to obtain the purified aluminum-based substrate, to ensure that impurities on the surface of the aluminum-based substrate are removed. The impurities include inorganic impurities and organic impurities, and the organic impurities include oil and grease substances.

In some examples, performing purification processing on the aluminum-based substrate includes: placing the aluminum-based substrate in an impurity removal solution, and soaking the aluminum-based substrate at 40°C to 70°C for 3 min to 10 min, so that the organic impurities such as oil, grease, and dirt on the aluminum-based substrate are decomposed by using the impurity removal solution, and the organic impurities together with the inorganic impurities detach from the surface of the aluminum-based substrate and enter the impurity removal solution.

For example, a soaking temperature for the purification processing includes but is not limited to 40°C, 45°C, 50°C, 55°C, 60°C, 65°C, 70°C, and the like, and a soaking time for the purification processing includes but is not limited to 3 min, 4 min, 5 min, 6 min, 7 min, 8 min, 9 min, 10 min, and the like.

In some examples, the impurity removal solution includes components in the following formulation: 3 g/L to 30 g/L of sodium hydroxide, 5 g/L to 50 g/L of a carbonate, 5 g/L to 20 g/L of a phosphate, 1 g/L to 20 g/L of a boron compound, 1 g/L to 10 g/L of a surfactant, and water as balance, so that a pH value of the impurity removal solution ranges from 8 to 10.

A concentration of the sodium hydroxide includes but is not limited to 5 g/L, 10 g/L, 15 g/L, 20 g/L, 25 g/L, and the like.

The carbonate may be at least one of sodium carbonate, potassium carbonate, sodium bicarbonate, and potassium bicarbonate. A concentration of the carbonate includes but is not limited to 5 g/L, 10 g/L, 15 g/L, 20 g/L, 25 g/L, 30 g/L, 35 g/L, 40 g/L, 45 g/L, 50 g/L, and the like.

The phosphate may be at least one of sodium phosphate, sodium hydrogen phosphate, sodium dihydrogen phosphate, potassium phosphate, potassium hydrogen phosphate, and potassium dihydrogen phosphate. A concentration of the phosphate includes but is not limited to 5 g/L, 10 g/L, 12 g/L, 15 g/L, 18 g/L, 20 g/L, and the like.

The boron compound may be at least one of dimethylamine borane, trimethylamine borane, diethylamine borane, triethylamine borane, and dicyclohexylamine borane. A concentration of the boron compound includes but is not limited to 5 g/L, 10 g/L, 12 g/L, 15 g/L, 18 g/L, 20 g/L, and the like.

The surfactant may be an anionic surfactant or a non-ionic surfactant, for example, at least one of alkylphenol ethoxylate and polyoxyethylene alkanolamide. A concentration of the surfactant includes but is not limited to 1 g/L, 2 g/L, 3 g/L, 4 g/L, 5 g/L, 6 g/L, 7 g/L, 8 g/L, 9 g/L, 10 g/L, and the like.

In this embodiment of the present disclosure, the aluminum-based substrate may be made of pure aluminum or an aluminum alloy. Some examples of the aluminum alloy include but are not limited to the following: an Al-Si alloy (with Si content of 0.5 wt% to 1 wt%), an Al-Cu alloy (with Cu content of 0.5 wt% to 1 wt%), and an Al-Si-Cu alloy (with Si and Cu in any proportion, but a total content of Si and Cu is less than or equal to 1 wt%).

In step S12, the metal protective layer is formed on the surface of the purified aluminum-based substrate to obtain the first composite material intermediate. It can be learned that the first composite material intermediate includes the aluminum-based substrate and the metal protective layer on the surface of the aluminum-based substrate.

In some examples, the metal protective layer may cover all surfaces of the aluminum-based substrate, to implement all-round protection for the aluminum-based substrate. Certainly, the metal protective layer may alternatively be arranged on only one of the surfaces of the aluminum-based substrate.

The metal protective layer may be formed on the surface of the aluminum-based substrate in a plurality of manners, for example, through electroless plating and the like, while the aluminum-based substrate is not damaged.

In this embodiment of the present disclosure, metals that can serve as sacrificial layers in the nickel electroplating process without damaging the aluminum-based substrate are applicable to preparation of the metal protective layer. For example, the metal protective layer includes but is not limited to a zinc layer. The zinc layer can effectively protect the aluminum-based substrate, and exhibits a simple and reliable preparation process that does not cause damage to the aluminum-based substrate.

When the metal protective layer is a zinc layer, forming the metal protective layer on the surface of the purified aluminum-based substrate to obtain the first composite material intermediate in this embodiment of the present disclosure includes: placing the purified aluminum-based substrate in a zinc plating solution and performing zinc plating processing, to form the zinc layer on the surface of the purified aluminum-based substrate and obtain the first composite material intermediate.

The zinc layer is plated on the surface of the aluminum-based substrate through electroless plating, which is easy to operate and makes a thickness of the zinc layer controllable. For example, the thickness of the zinc layer may be adjusted by adjusting at least one of the following parameters: a concentration of zinc oxide in the zinc plating solution, and a time of the zinc plating processing.

In some examples, the zinc plating solution includes components in the following formulation: 50 g/L to 200 g/L of sodium hydroxide, 5 g/L to 50 g/L of potassium sodium tartrate, 1 g/L to 10 g/L of zinc oxide, 0.2 g/L to 2 g/L of iron and ferrous compounds, and water as balance, so that a pH value of the zinc plating solution ranges from 12 to 14.

A concentration of the sodium hydroxide includes but is not limited to 50 g/L, 60 g/L, 70 g/L, 80 g/L, 90 g/L, 100 g/L, 110 g/L, 120 g/L, 130 g/L, 140 g/L, 150 g/L, 160 g/L, 170 g/L, 180 g/L, 190 g/L, 200 g/L, and the like.

A concentration of the potassium sodium tartrate includes but is not limited to 5 g/L, 10 g/L, 15 g/L, 20 g/L, 25 g/L, 30 g/L, 35 g/L, 40 g/L, 45 g/L, 50 g/L, and the like.

The concentration of zinc oxide includes but is not limited to 1 g/L, 2 g/L, 3 g/L, 4 g/L, 5 g/L, 6 g/L, 7 g/L, 8 g/L, 9 g/L, 10 g/L, and the like.

The iron compound may be at least one of ferric chloride, ferric sulfate, ferric nitrate, and ferrocene. The ferrous compound may be at least one of ferrous sulfate and ferrous gluconate. A concentration of the iron compound or a concentration of the ferrous compound includes but is not limited to 0.2 g/L, 0.3 g/L, 0.4 g/L, 0.5 g/L, 0.6 g/L, 0.7 g/L, 0.8 g/L, 0.9 g/L, 1 g/L, 1.1 g/L, 1.2 g/L, 1.3 g/L, 1.4 g/L, 1.5 g/L, 1.6 g/L, 1.7 g/L, 1.8 g/L, 1.9 g/L, 2 g/L, and the like.

The zinc plating solution is an alkaline solution. The zinc oxide ZnO dissolves in the alkaline solution to form Zn(OH)₄²⁻, causing the aluminum-based substrate to undergo the following displacement reaction in the zinc plating solution:
Al + Zn(OH)₄²⁻ → AlO²⁻ + Zn + H₂O + OH⁻ + 1/2H₂. It can be learned that in the zinc plating process, an Al₂O₃ film is removed and regeneration of the Al₂O₃ film is inhibited, and the Zn element is displaced, so that the zinc layer is formed on the surface of the aluminum-based substrate, and regeneration of the Al₂O₃ film on the aluminum-based substrate is prevented.

The aluminum-based substrate is processed by using the foregoing zinc plating solution to remove the Al₂O₃ film and inhibit regeneration of the Al₂O₃ film, thereby exposing the aluminum-based surface of the aluminum-based substrate and bringing the aluminum-based surface to a desired pre-plating condition. In this way, the first metal plating layer can be grown on the surface of the aluminum-based substrate after the zinc layer is sacrificed.

**In** some examples, a temperature of the zinc plating processing ranges from 20°C to 30°C, and the time of the zinc plating processing ranges from 5s to 20s. For example, the temperature of the zinc plating processing includes but is not limited to 20°C, 21°C, 22°C, 23°C, 24°C, 25°C, 26°C, 27°C, 28°C, 29°C, 30°C, and the like; and the time of the zinc plating processing includes but is not limited to 5s, 6s, 7s, 8s, 9s, 10s, 11s, 12s, 13s, 14s, 15s, 16s, 17s, 18s, 19s, 20s, and the like.

Operation parameters of the zinc plating processing are specified within the foregoing ranges respectively, achieving advantages of making the surface of the aluminum-based substrate flat and preventing generation of an oxide film.

In some examples, placing the purified aluminum-based substrate in the zinc plating solution and performing the zinc plating processing, to form the zinc layer on the surface of the purified aluminum-based substrate and obtain the first composite material intermediate includes:
placing the purified aluminum-based substrate in the zinc plating solution and performing first zinc plating processing, to form a to-be-removed zinc layer on the surface of the purified aluminum-based substrate;
performing acid pickling on the aluminum-based substrate with the to-be-removed zinc layer on the surface, to remove the to-be-removed zinc layer and obtain the aluminum-based substrate whose surface is exposed; and
performing second zinc plating processing on the aluminum-based substrate whose surface is exposed, to form a target zinc layer on the exposed surface of the aluminum-based substrate and obtain the first composite material intermediate.

The zinc layer that is formed for the first time is stripped off by acid, which helps bring the exposed surface of the aluminum-based substrate to a more excellent plateable condition. Further, zinc plating is performed again on the exposed surface of the aluminum-based substrate, to obtain a more activated, more compact, and flatter zinc layer.

For example, an operation condition of the first zinc plating processing is that a temperature of the zinc plating processing ranges from 20°C to 30°C, and a time of the zinc plating processing ranges from 8s to 20s; and an operation condition of the second zinc plating processing is that a temperature of the zinc plating processing ranges from 20°C to 30°C, and a time of the zinc plating processing ranges from 5s to 20s.

For example, the acid pickling uses a nitric acid solution with a mass concentration of 20% to 40%, for example, may use a nitric acid solution with a mass concentration of 30%. A temperature of the acid pickling may range from 20°C to 30°C, which includes but is not limited to 20°C, 21°C, 22°C, 23°C, 24°C, 25°C, 26°C, 27°C, 28°C, 29°C, 30°C, and the like. A time of the acid pickling may range from 1s to 5s, which includes but is not limited to 1s, 2s, 3s, 4s, 5s, and the like.

In some examples, a thickness of the metal protective layer, for example, the zinc layer, ranges from 1 nm to 100 nm. Further, the thickness ranges from 1 nm to 50 nm, which includes but is not limited to 5 nm, 10 nm, 15 nm, 20 nm, 25 nm, 30 nm, 35 nm, 40 nm, 45 nm, 50 nm, and the like.

The metal protective layer may be continuous or discontinuous. For example, when the thickness of the metal protective layer is less than 20 nm, the metal protective layer may be discontinuous and exhibit a dispersed island-like distribution.

In step S13, the first electroplating processing is performed on the first composite material intermediate, so that the metal protective layer is corroded to form the first metal plating layer on the surface of the aluminum-based substrate and obtain the second composite material intermediate.

For example, the first metal plating layer is a nickel plating layer, and the first electroplating processing uses a nickel plating solution. In the nickel electroplating process, the nickel plating solution corrodes the metal protective layer, for example, the zinc layer, and a formed nickel plating layer is formed on the exposed surface of the aluminum-based substrate. Because grains of the nickel plating layer obtained through electroplating grow fine and dense, the compact and uniform nickel plating layer is electroplated on the surface of the aluminum-based substrate, so that the nickel plating layer can effectively resist oxidation and corrosion.

In some examples, the nickel plating solution provided in this embodiment of the present disclosure includes components in the following formulation: 1 g/L to 50 g/L of nickel sulfate, 1 g/L to 50 g/L of nickel chloride, 1 g/L to 50 g/L of nickel methanesulfonate, 1 g/L to 50 g/L of hydrochloric acid, 1 g/L to 10 g/L of a primary brightener, 0.1 g/L to 1 g/L of an auxiliary brightener, and water as balance.

The nickel plating solution based on the foregoing formulation has advantages such as stable chemical properties, a long service life, making the nickel plating process stable and controllable, and making the nickel plating layer compact and flat. A mass concentration of the hydrochloric acid may range from 30% to 40%. For example, hydrochloric acid with a mass concentration of 36% is used.

A concentration of the nickel sulfate includes but is not limited to 2 g/L, 5 g/L, 10 g/L, 15 g/L, 20 g/L, 25 g/L, 30 g/L, 35 g/L, 40 g/L, 45 g/L, 50 g/L, and the like.

A concentration of the nickel chloride includes but is not limited to 1 g/L, 5 g/L, 10 g/L, 15 g/L, 20 g/L, 25 g/L, 30 g/L, 35 g/L, 40 g/L, 45 g/L, 50 g/L, and the like.

A concentration of the nickel methanesulfonate includes but is not limited to 2 g/L, 6 g/L, 10 g/L, 17 g/L, 20 g/L, 25 g/L, 30 g/L, 35 g/L, 40 g/L, 45 g/L, 50 g/L, and the like.

A concentration of the hydrochloric acid includes but is not limited to 2 g/L, 5 g/L, 10 g/L, 15 g/L, 20 g/L, 25 g/L, 30 g/L, 35 g/L, 40 g/L, 45 g/L, 50 g/L, and the like.

A concentration of the primary brightener includes but is not limited to 1 g/L, 2 g/L, 3 g/L, 4 g/L, 5 g/L, 6 g/L, 7 g/L, 8 g/L, 9 g/L, 10 g/L, and the like.

The primary brightener includes but is not limited to at least one of sodium saccharin, bis(phenylsulfonyl) sulfinic acid, coumarin (2H-chromen-2-one), 1,4-butynediol, pyridinium propyl sulfobetaine, N,N-diethylpropargylamine, and ethoxylated propargyl alcohol.

A concentration of the auxiliary brightener includes but is not limited to 0.2 g/L, 0.3 g/L, 0.4 g/L, 0.5 g/L, 0.6 g/L, 0.7 g/L, 0.8 g/L, 0.9 g/L, 1 g/L, and the like.

The auxiliary brightener includes but is not limited to at least one of sodium vinylsulfonate, sodium styrene sulfonate, sodium allylsulfonate, allyl sulfonamide, and sodium propargyl sulfonate.

In some examples, during the first electroplating processing, a current density ranges from 0.1 ASD to 5 ASD, and an electroplating temperature ranges from 45°C to 65°C. Operation parameters of nickel electroplating are specified as above, achieving advantages such as increasing a plating rate, making a plating film uniform in thickness, and making a film layer compact and flat.

According to tests, a plating rate in the nickel plating in this embodiment of the present disclosure can reach 1.5 µm/min, compared with a plating rate of 0.15 µm/min in electroless plating, so that a time consumed by a technical process in this embodiment of the present disclosure is 5 to 10 times shorter.

For example, the current density includes but is not limited to 0.5 ASD, 1 ASD, 1.1 ASD, 1.2 ASD, 1.3 ASD, 1.4 ASD, 1.5 ASD, 1.6 ASD, 1.7 ASD, 1.8 ASD, 1.9 ASD, 2 ASD, 2.1 ASD, 2.2 ASD, 2.3 ASD, 2.4 ASD, 2.5 ASD, 2.6 ASD, 2.7 ASD, 2.8 ASD, 2.9 ASD, 3 ASD, 3.1 ASD, 3.2 ASD, 3.3 ASD, 3.4 ASD, 3.5 ASD, 4 ASD, 4.5 ASD, 5 ASD, and the like.

The electroplating temperature includes but is not limited to 45°C, 46°C, 47°C, 48°C, 49°C, 50°C, 51°C, 52°C, 53°C, 54°C, 55°C, 56°C, 57°C, 58°C, 59°C, 60°C, 61°C, 62°C, 63°C, 64°C, 65°C, and the like.

In some examples, an electroplating time for the nickel plating may range from 1 minute to 5 minutes, and a thickness of the nickel plating layer may be controlled by controlling at least one of the current density and the electroplating time. For example, the thickness of the nickel plating layer may range from 0.5 µm to 5 µm.

With a purity of up to 99.9%, the nickel plating layer is made of pure nickel and free from impurity atoms, and can fully cover the aluminum-based substrate. In some examples, the nickel plating layer covers all the surfaces of the aluminum-based substrate.

Under observation with a scanning electron microscope (Scanning Electron Microscope, SEM) or a transmission electron microscope (Transmission Electron Microscope, TEM), a cell diameter of the nickel plating layer prepared through the first electroplating processing in this embodiment of the present disclosure is less than or equal to 100 nm, and lattices in the nickel plating layer are compact, so that the nickel plating layer is uniform and compact.

In step S14, the second electroplating processing is performed on the second composite material intermediate to form the second metal plating layer on the surface of the first metal plating layer and obtain the aluminum matrix composite material.

For example, the first metal plating layer is a nickel plating layer, the second metal plating layer is a nickel plating layer, and the second electroplating processing uses a gold plating solution. Because grains of the gold plating layer obtained through electroplating grow fine and dense, the compact and uniform gold plating layer is electroplated on a surface of the nickel plating layer, so that the gold plating layer can effectively resist oxidation and corrosion.

In some examples, the gold plating solution provided in this embodiment of the present disclosure includes components in the following formulation: 10 g/L to 20 g/L of gold trichloride, 50 g/L to 130 g/L of sodium sulfite, 30 g/L to 50 g/L of ethylenediaminetetraacetic acid, 30 g/L to 50 g/L of citric acid, 50 g/L to 80 g/L of potassium chloride, and water as balance. The gold plating solution based on the foregoing formulation has advantages such as increasing a plating rate, making a plating film uniform in thickness, making the gold plating process stable and controllable, and making the gold plating layer compact and flat.

A concentration of gold trichloride includes but is not limited to 10 g/L, 11 g/L, 12 g/L, 13 g/L, 14 g/L, 15 g/L, 16 g/L, 17 g/L, 18 g/L, 19 g/L, 20 g/L, and the like.

A concentration of sodium sulfite includes but is not limited to 50 g/L, 55 g/L, 60 g/L, 65 g/L, 70 g/L, 75 g/L, 80 g/L, 85 g/L, 90 g/L, 95 g/L, 100 g/L, 105 g/L, 110 g/L, 115 g/L, 120 g/L, 125 g/L, 130 g/L, and the like.

A concentration of ethylenediaminetetraacetic acid includes but is not limited to 30 g/L, 33 g/L, 35 g/L, 37 g/L, 40 g/L, 42 g/L, 43 g/L, 44 g/L, 45 g/L, 46 g/L, 47 g/L, 48 g/L, 49 g/L, 50 g/L, and the like.

A concentration of citric acid includes but is not limited to 30 g/L, 32 g/L, 35 g/L, 38 g/L, 39 g/L, 40 g/L, 42 g/L, 43 g/L, 44 g/L, 45 g/L, 46 g/L, 47 g/L, 48 g/L, 49 g/L, 50 g/L, and the like.

A concentration of potassium chloride includes but is not limited to 50 g/L, 52 g/L, 55 g/L, 57 g/L, 60 g/L, 63 g/L, 65 g/L, 68 g/L, 70 g/L, 72 g/L, 75 g/L, 76 g/L, 79 g/L, 80 g/L, and the like.

In some examples, during the gold electroplating processing, a current density ranges from 0.1 ASD to 5 ASD, and an electroplating temperature ranges from 30°C to 45°C. Operation parameters of gold electroplating are specified as above, achieving advantages such as increasing the plating rate, making the plating film uniform in thickness, making the gold plating process stable and controllable, and making the gold plating layer compact and flat.

According to tests, a plating rate in the gold plating in this embodiment of the present disclosure can reach 1.5 µm/min, compared with a plating rate of 0.15 µm/min in electroless plating, so that a time consumed by a technical process in this embodiment of the present disclosure is 5 to 10 times shorter.

For example, the current density includes but is not limited to 0.2 ASD, 0.21 ASD, 0.22 ASD, 0.23 ASD, 0.24 ASD, 0.25 ASD, 0.26 ASD, 0.27 ASD, 0.28 ASD, 0.29 ASD, 0.3 ASD, 0.31 ASD, 0.32 ASD, 0.33 ASD, 0.34 ASD, 0.35 ASD, 0.36 ASD, 0.37 ASD, 0.38 ASD, 0.39 ASD, 0.4 ASD, 0.45 ASD, 0.47 ASD, 0.5 ASD, 0.6 ASD, 0.7 ASD, 0.8 ASD, 0.9 ASD, 1 ASD, 2 ASD, 3 ASD, 4 ASD, 5 ASD, and the like.

The electroplating temperature includes but is not limited to 30°C, 31°C, 32°C, 33°C, 34°C, 35°C, 36°C, 37°C, 38°C, 39°C, 40°C, 41°C, 42°C, 43°C, 44°C, 45°C, and the like.

In some examples, an electroplating time for the gold plating may range from 1 minute to 5 minutes, and a thickness of the gold plating layer may be controlled by controlling at least one of the current density and the electroplating time. For example, the thickness of the gold plating layer may range from 0.1 µm to 2 µm.

With a purity of up to 99.9%, the gold plating layer is made of pure gold and free from impurity atoms, and can fully cover the nickel plating layer. In some examples, the gold plating layer covers all surfaces of the nickel plating layer. Post-processing may be performed according to an actual requirement, to remove the gold plating layer and the nickel plating layer on one or more surfaces of the aluminum matrix composite material and expose the aluminum-based substrate on the one or more surfaces of the aluminum matrix composite material. Certainly, at least one surface of the aluminum matrix composite material is provided with both the gold plating layer and the nickel plating layer.

Under observation with an SEM or a TEM, a cell diameter of the gold plating layer prepared through the second electroplating processing in this embodiment of the present disclosure is less than or equal to 100 nm, and lattices in the gold plating layer are compact, so that the gold plating layer is uniform and compact.

In some possible implementations, the preparation method for the aluminum matrix composite material provided in this embodiment of the present disclosure further includes: before performing the zinc plating processing on the purified aluminum-based substrate, performing surface etching processing on the purified aluminum-based substrate, so that a rough structure is formed on the surface of the purified aluminum-based substrate, where the rough structure is configured to enhance a bonding force between the aluminum-based substrate and the nickel plating layer.

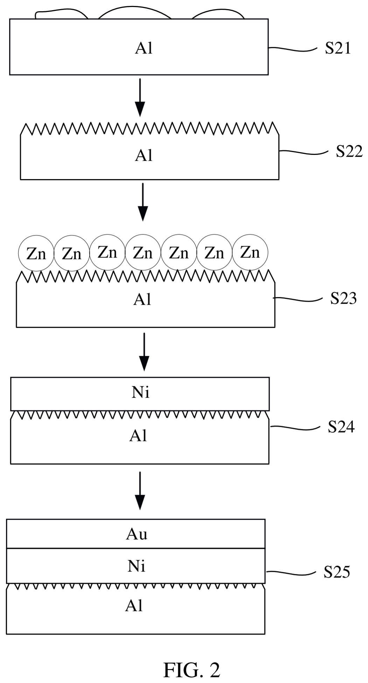

With reference to FIG. 2, that is, the preparation method for the aluminum matrix composite material provided in this embodiment of the present disclosure includes the following steps.

Step S21: Perform purification processing on an aluminum-based substrate to obtain a purified aluminum-based substrate.

Step S22: Perform surface etching processing on the purified aluminum-based substrate, so that a rough structure is formed on a surface of the purified aluminum-based substrate.

Step S23: Form a metal protective layer on the surface on which the rough structure is provided and that is of the aluminum-based substrate, to obtain a first composite material intermediate.

Step S24: Perform first electroplating processing on the first composite material intermediate, so that the metal protective layer is corroded by a first metal plating layer to form the first metal plating layer on the surface of the aluminum-based substrate and obtain a second composite material intermediate.

Step S25: Perform second electroplating processing on the second composite material intermediate to form a second metal plating layer on a surface of the first metal plating layer and obtain the aluminum matrix composite material.

The rough structure is formed on the surface of the purified aluminum-based substrate through etching processing, thereby increasing a specific surface area of the purified aluminum-based substrate. This helps enhance strength of bonding between the aluminum-based substrate and the first metal plating layer. Dimensions of the rough structure are at a micro- to nanometer scale, ensuring that surface flatness of the aluminum-based substrate is not affected while a surface bonding force of the aluminum-based substrate is enhanced.

In some examples, to make the dimensions (for example, a depth) of the rough structure easier to control, the purified aluminum-based substrate is placed in an etching solution to perform the surface etching processing. The dimensions of the formed rough structure may be correspondingly controlled by controlling an etching time.

For example, the etching solution includes components in the following formulation, so that the etching solution has advantages of a low etching rate and uniform etching: 10 g/L to 50 g/L of tetramethylammonium hydroxide, 10 g/L to 50 g/L of disodium ethylenediaminetetraacetate (EDTA2Na), 5 g/L to 20 g/L of zinc oxide, 5 g/L to 20 g/L of barbituric acid, 0.1 g/L to 1 g/L of a soluble silver salt, and water as balance, so that a pH value of the etching solution ranges from 10 to 13.

A concentration of the tetramethylammonium hydroxide includes but is not limited to 10 g/L, 15 g/L, 20 g/L, 25 g/L, 30 g/L, 35 g/L, 40 g/L, 45 g/L, 50 g/L, and the like.

A concentration of the disodium ethylenediaminetetraacetate includes but is not limited to 10 g/L, 15 g/L, 20 g/L, 25 g/L, 30 g/L, 35 g/L, 40 g/L, 45 g/L, 50 g/L, and the like.

A concentration of zinc oxide includes but is not limited to 5 g/L, 8 g/L, 10 g/L, 12 g/L, 15 g/L, 16 g/L, 18 g/L, 20 g/L, and the like.

A concentration of barbituric acid includes but is not limited to 5 g/L, 7 g/L, 10 g/L, 12 g/L, 15 g/L, 17 g/L, 18 g/L, 20 g/L, and the like.

The soluble silver salt may be silver nitrate, silver fluoride, silver chlorate, silver perchlorate, or the like. A concentration of the soluble silver salt includes but is not limited to 0.1 g/L, 0.2 g/L, 0.3 g/L, 0.4 g/L, 0.5 g/L, 0.6 g/L, 0.7 g/L, 0.8 g/L, 0.9 g/L, 1 g/L, and the like.

In some examples, the purified aluminum-based substrate may be placed in the etching solution and soaked at 20°C to 40°C for 1 min to 5 min, and surface etching processing may be performed, to obtain a rough structure of micro- to nanometer dimensions on the surface of the aluminum-based substrate. For example, a soaking temperature includes but is not limited to 20°C, 21°C, 22°C, 23°C, 24°C, 25°C, 26°C, 27°C, 28°C, 29°C, 30°C, 31°C, 32°C, 33°C, 34°C, 35°C, 36°C, 37°C, 38°C, 39°C, 40°C, and the like. A soaking time includes but is not limited to 1 min, 2 min, 3 min, 4 min, 5 min, and the like.

In conclusion, the preparation method for the aluminum matrix composite material provided in this embodiment of the present disclosure can effectively avoid phenomena such as a loose plating layer and a nickel nodule in electroless nickel immersion gold, and eliminate adverse factors such as a black pad and a galvanic effect. The preparation method for the aluminum matrix composite material is easy to operate, features low costs, and can effectively protect the aluminum-based substrate.

In another aspect, an embodiment of the present disclosure provides an aluminum matrix composite material. The aluminum matrix composite material includes an aluminum-based substrate, a first metal plating layer, and a second metal plating layer that are sequentially stacked; a cell diameter of the first metal plating layer is less than or equal to 100 nm; and a cell diameter of the second metal plating layer is less than or equal to 100 nm.

The cell diameter of the first metal plating layer in this embodiment of the present disclosure is a diagonal length of a single cell in an SEM image that represents cells of the first metal plating layer. The cell diameter of the second metal plating layer in this embodiment of the present disclosure is a diagonal length of a single cell in an SEM image that represents cells of the second metal plating layer.

For example, the first metal plating layer is a nickel plating layer, the second metal plating layer is a gold plating layer, and the aluminum matrix composite material includes the aluminum-based substrate, the nickel plating layer, and the gold plating layer that are sequentially stacked. A cell diameter of the nickel plating layer is less than or equal to 100 nm, and a cell diameter of the gold plating layer is less than or equal to 100 nm.

The cell diameter of the nickel plating layer and the cell diameter of the gold plating layer can both be measured using a scanning electron microscope (Scanning Electron Microscope, SEM) or a transmission electron microscope (Transmission Electron Microscope, TEM).

A cell of a nickel (Ni) crystal is a face-centered cube, namely, a face-centered cubic close-packed structure, where there is a nickel atom at each of eight vertexes of the cube and at a center of each of six faces of the cube. The cell diameter of the nickel plating layer in this embodiment of the present disclosure is a diagonal length of a single cell in an SEM image that represents cells of the nickel plating layer.

A cell of a gold (Au) crystal is a face-centered cube, namely, a face-centered cubic close-packed structure, where there is a gold atom at each of eight vertexes of the cube and at a center of each of six faces of the cube. The cell diameter of the gold plating layer in this embodiment of the present disclosure is a diagonal length of a single cell in an SEM image that represents cells of the gold plating layer.

According to the aluminum matrix composite material provided in this embodiment of the present disclosure, the cell diameter of the nickel plating layer of the aluminum matrix composite material is less than or equal to 100 nm, and lattices in the nickel plating layer are compact, so that the nickel plating layer is uniform and compact. The cell diameter of the gold plating layer of the aluminum matrix composite material is less than or equal to 100 nm, and lattices in the gold plating layer are compact, so that the gold plating layer is uniform and compact, and provides excellent coverage for the nickel plating layer. The compact nickel plating layer and the compact gold plating layer avoid mutual diffusion of the nickel element and the gold element, thereby avoiding a galvanic effect and a black pad problem. This improves stability of the nickel plating layer and the gold plating layer, thereby making corrosion resistance and oxidation resistance of the nickel plating layer and the gold plating layer more stable. In addition, surface flatness and uniformity of the gold plating layer facilitate soldering and gold wire bonding.

In some implementations, according to tests, in the aluminum matrix composite material provided in this embodiment of the present disclosure, a surface roughness Ra of the nickel plating layer is less than or equal to 20 nm, and
a surface roughness Ra of the gold plating layer is less than or equal to 20 nm.

It can be learned from the foregoing parameters that both the nickel plating layer and the gold plating layer maintain a high flatness. This particularly helps improve properties such as compactness, oxidation resistance, and corrosion resistance of the nickel plating layer and the gold plating layer.

In some possible implementations, a rough structure is provided on a surface that is of the aluminum-based substrate and on which the aluminum-based substrate and the nickel plating layer are bonded to each other, and the rough structure is configured to enhance a bonding force between the aluminum-based substrate and the first metal plating layer, for example, the nickel plating layer, so that the first metal plating layer is stably adhered to the aluminum-based substrate. A formation manner and dimensions of the rough structure are as described above.

In some examples, the aluminum matrix composite material may be a pad structure.

In still another aspect, an embodiment of the present disclosure further provides an electronic device, where the electronic device includes a device body and a pad structure, the pad structure is connected to the device body, and the pad structure is prepared by using the aluminum matrix composite material according to any one of the foregoing implementations.

A device body provided with a pad made of an aluminum-based material may be directly processed by using the foregoing preparation method in embodiments of the present disclosure, to sequentially plate a metal protective layer (for example, a zinc layer), a first metal plating layer (for example, electroplated nickel), and a second metal plating layer (for example, electroplated gold) on the pad made of the aluminum-based material on the device body. Alternatively, the pad structure may be directly prepared by using a finished aluminum matrix composite material, and then the pad structure is connected to the device body.

The electronic device provided in this embodiment of the present disclosure has all the advantages of the aluminum matrix composite material provided in embodiments of the present disclosure.

In some examples, the electronic device includes but is not limited to a chip, a printed circuit board, and the like. The chip and the printed circuit board are provided with a pad structure. The pad structure includes a conductive pillar and pads, where the conductive pillar is the foregoing aluminum-based substrate, and the pads are the foregoing first metal plating layer and second metal plating layer that are stacked, for example, the nickel plating layer and the gold plating layer.

The electronic device such as the chip or the printed circuit board uses the pad structure based on the aluminum matrix composite material in embodiments of the present disclosure, so that the pad structure can implement an efficient and reliable soldering operation and can be further used for gold wire bonding, molding, and the like.

The following describes in more detail some specific implementations of the present disclosure. Although the following describes preferred implementations of the present disclosure, it should be understood that the present disclosure may be implemented in various forms and should not be limited to the implementations described herein. If no specific technology or condition is specified in embodiments, a technology or condition described in the literature in the art or a product specification shall be followed. Reagents or instruments used with no indication of manufacturers are conventional products that are commercially available.

### Embodiment 1 to Embodiment 3

Embodiment 1 to Embodiment 3 each provide a preparation method for an aluminum matrix composite material and an aluminum matrix composite material obtained according to the preparation method. The preparation methods for the aluminum matrix composite materials in Embodiment 1 to Embodiment 3 are all as follows, and differences lie in parameters shown in Table 1.

Step 1: Place an aluminum-based substrate in an impurity removal solution, soak the aluminum-based substrate at 50°C for 5 min, so that organic impurities such as oil, grease, and dirt on the aluminum-based substrate are decomposed by using the impurity removal solution, to obtain a purified aluminum-based substrate.

The impurity removal solution includes components in the following formulation: 20 g/L of sodium hydroxide, 30 g/L of sodium carbonate, 10 g/L of sodium phosphate, 10 g/L of dimethylamine borane, 50 g/L of nonylphenol ethoxylate, and water as balance, so that a pH value of the impurity removal solution is 9.

Step 2: Place the purified aluminum-based substrate in an etching solution, soak the purified aluminum-based substrate at 30°C for 2 min, and perform surface etching processing on the aluminum-based substrate.

The etching solution includes components in the following formulation: 30 g/L of tetramethylammonium hydroxide, 30 g/L of EDTA2Na, 10 g/L of zinc oxide, 10 g/L of barbituric acid, 5 g/L of silver nitrate, and water as balance, so that a pH value of the etching solution is 13.

Step 3: Place the purified aluminum-based substrate in a zinc plating solution, and perform zinc plating processing at 25°C for 10 minutes; next, place the purified aluminum-based substrate in a nitric acid solution with a mass concentration of 30%, and perform acid pickling at 25°C for 2 minutes; and then continue to place the purified aluminum-based substrate in a new zinc plating solution, and perform zinc plating processing at 25°C for 8 minutes to 15 minutes, to form a zinc layer on a surface of the purified aluminum-based substrate and obtain a first composite material intermediate.

A thickness of the formed zinc layer is determined based on the times of the two zinc plating processes. For a thickness of a zinc layer in each embodiment, refer to Table 1. The zinc plating solution includes components in the following formulation: 100 g/L of sodium hydroxide, 30 g/L of potassium sodium tartrate, 5 g/L of zinc oxide, 1 g/L of ferric chloride, and water as balance, so that a pH value of the zinc plating solution is 13.

Step 4: Perform nickel electroplating processing on the first composite material intermediate, so that the metal protective layer is corroded by the nickel plating solution to form a nickel plating layer on the surface of the aluminum-based substrate and obtain a second composite material intermediate.

A thickness of the formed nickel plating layer is determined based on a time of the nickel electroplating processing. For a time of nickel electroplating processing and a thickness of a nickel plating layer in each embodiment, refer to Table 1.

During the nickel electroplating processing, a current density is 1.5 ASD and an electroplating temperature is 55°C. The used nickel plating solution includes components in the following formulation: 30 g/L of nickel sulfate, 25 g/L of nickel chloride, 20 g/L of nickel methanesulfonate, 30 g/L of hydrochloric acid, 8 g/L of bis(phenylsulfonyl) sulfinic acid (BBI), 0.5 g/L of sodium styrene sulfonate, and water as balance.

Step 5: Perform gold electroplating processing on the second composite material intermediate to form a gold plating layer on a surface of the nickel plating layer and obtain the aluminum matrix composite material.

A thickness of the formed gold plating layer is determined based on a time of the gold electroplating processing. For a time of gold electroplating processing and a thickness of a gold plating layer in each embodiment, refer to Table 1.

During the gold electroplating processing, a current density is 0.3 ASD and an electroplating temperature is 37°C. The used gold plating solution includes components in the following formulation: 15 g/L of gold trichloride, 100 g/L of sodium sulfite, 45 g/L of ethylenediaminetetraacetic acid, 30 g/L of citric acid, 60 g/L of potassium chloride, and water as balance.

### Comparative Example 1 and Comparative Example 2

Comparative Example 1 and Comparative Example 2 each provide an aluminum matrix composite material obtained through electroless plating. In Comparative Example 1 and Comparative Example 2, before electroless nickel plating and electroless gold plating are performed, purification, etching, and zinc plating processing are sequentially performed on the aluminum-based substrate. For the purification, etching, and zinc plating processing procedures, refer to the purification, etching, and zinc plating processing procedures in Embodiment 1 to Embodiment 3.

An electroless nickel plating solution used for the electroless nickel plating is a commercially available product purchased from Uyemura Corporation with a model number NMR-2. An electroless nickel plating temperature is 80°C, and an electroless nickel plating time is 15 min.

Electroless gold plating solutions used for the electroless gold plating are commercially available products purchased from Uyemura Corporation with model numbers TUF-1 (Comparative Example 1) and TUF-41 (Comparative Example 2). An electroless gold plating temperature in Comparative Example 1 is 74°C, and an electroless gold plating temperature in Comparative Example 2 is 50°C.

For some parameters that are different in the aluminum matrix composite materials provided in Embodiment 1 to Embodiment 3 and Comparative Example 1 to Comparative Example 3, and the preparation methods therefor, refer to Table 1.

**Table 1**

| Item | Embodiment 1 | Embodiment 2 | Embodiment 3 | Comparative Example 1 | Comparative Example 2 |
|---|---|---|---|---|---|
| Aluminum-based substrate | Pure aluminum | Pure aluminum | Aluminum-copper alloy | Aluminum-silicon-copper alloy | Pure aluminum |
| Thickness of a zinc layer | 10 nm | 20 nm | 10 nm | 10 nm | 5 nm |
| Thickness of a nickel plating | 1.5 µm | 3 µm | 1.5 µm | 3 µm | 1.5 µm |
| layer | | | | | |
| Nickel plating time | 3 min | 5 min | 3 min | 5 min | 3 min |
| Thickness of a gold plating layer | 0.1 µm | 0.3 µm | 0.1 µm | 0.3 µm | 0.1 µm |
| Gold plating time | 1 min | 2.5 min | 1 min | 2.5 min | 1 min |

### Test Example 1

Wire bond strength tests for package devices are performed according to the standard JESD22-B116. In Test Example 1, a gold wire bond (gold wire bonding) joint pull test is performed on the aluminum matrix composite materials provided in Embodiment 1 to Embodiment 3, and Comparative Example 1 and Comparative Example 2.

Results of minimum bond joint pull strength values obtained through the gold wire bond joint pull test are as shown in Table 2.

**Table 2**

| Item | Embodiment 1 | Embodiment 2 | Embodiment 3 | Comparative Example 1 | Comparative Example 2 |
|---|---|---|---|---|---|
| Minimum pull strength value | 13.7 g | 14.6 g | 13.8 g | 13.5 g | 12.1 g |

It can be learned from Table 2 that, in the aluminum matrix composite materials provided in Embodiment 1 to Embodiment 3, after the plating layers of the aluminum matrix composite materials are bonded with gold wires as pads, bonding strengths of the plating layers are higher than bonding strengths of the plating layers in the comparative examples. This indicates that the obtained plating layers are flat, uniform, and highly compact, which helps improve performance of gold wire bonding.

### Test Example 2

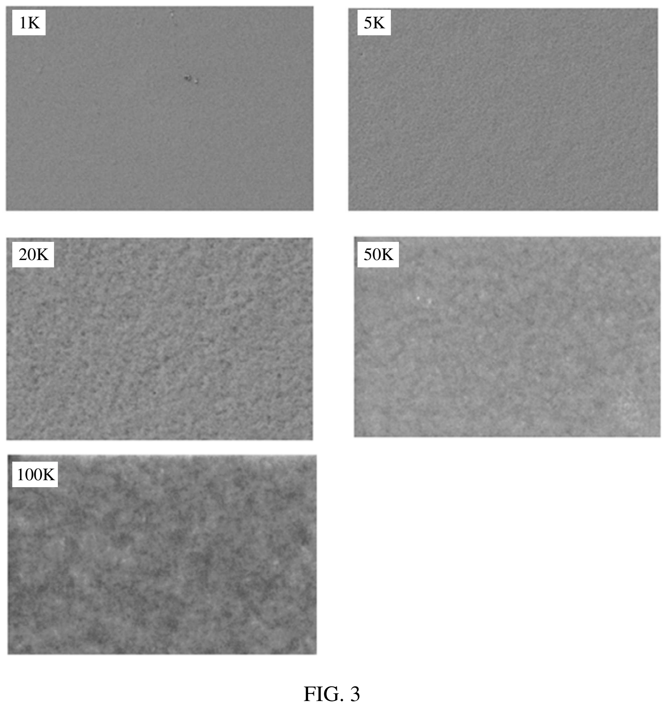

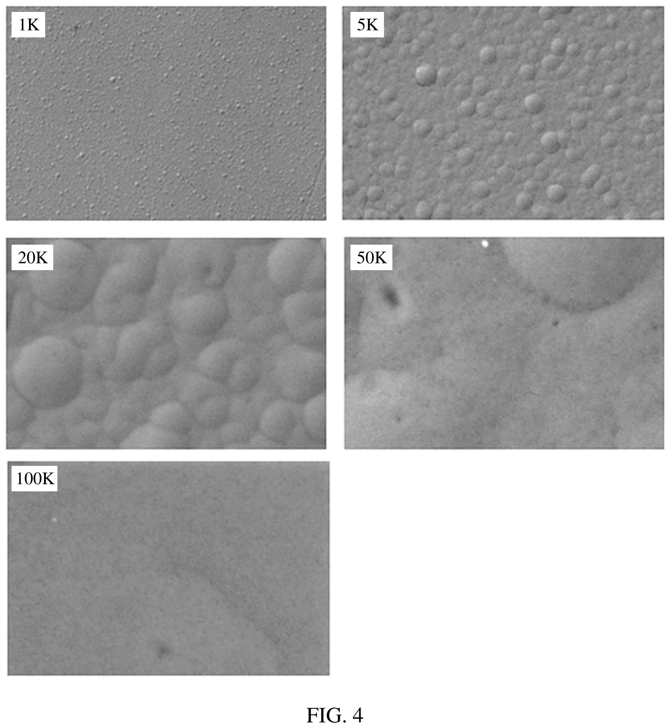

In Test Example 2, an SEM test is performed on surface morphology of the nickel plating layer of the aluminum matrix composite material provided in Embodiment 1 and surface morphology of the nickel plating layer of the aluminum matrix composite material provided in Comparative Example 2, where the nickel plating layer is exposed on the surface of the aluminum-based substrate in the second composite material intermediate. That is, the SEM test may be performed on the nickel plating layers of the second composite material intermediates of the corresponding aluminum matrix composite materials. For test results, refer to FIG. 3 and FIG. 4.

FIG. 3 shows an example of magnified morphology of the nickel plating layer of the aluminum matrix composite material according to Embodiment 1 at different magnifications, where magnifications of a scanning electron microscope are 1K, 5K, 20K, 50K, and 100K.

FIG. 4 shows an example of magnified morphology of the nickel plating layer of the aluminum matrix composite material according to Comparative Example 1 at different magnifications, where magnifications of a scanning electron microscope are 1K, 5K, 20K, 50K, and 100K.

It can be learned from FIG. 3 that, the nickel plating layer of the aluminum matrix composite material provided in Embodiment 1 exhibits a flat and uniform surface, compact lattices, no spherical nodule or pore, and a small cell size (< 100 nm). As a result, the nickel plating layer features high stability and can effectively resist oxidation and corrosion.

It can be learned from FIG. 4 that, the nickel plating layer of the aluminum matrix composite material provided in Comparative Example 1 exhibits a surface with spherical nodules, a large cell size (> 200 nm), poor flatness, and a small quantity of pores in some areas. As a result, the nickel plating layer exhibits poor stability and is susceptible to accelerated corrosion.

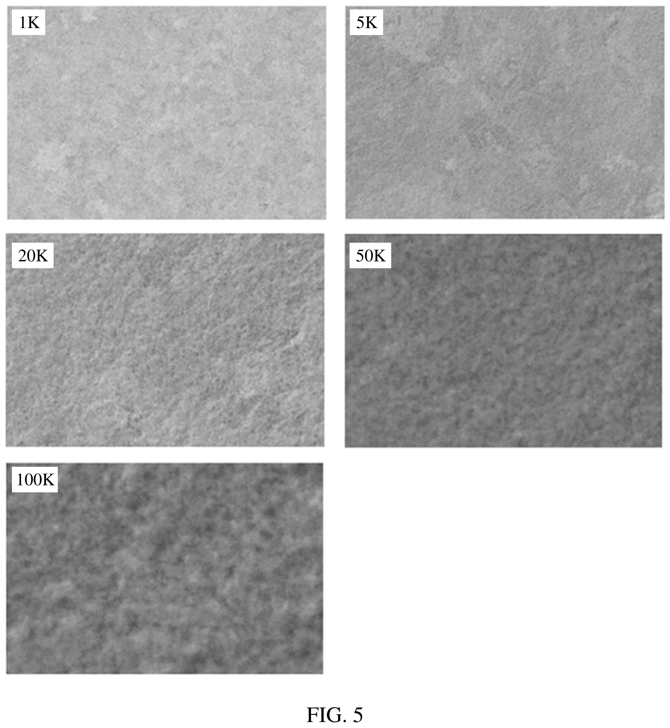

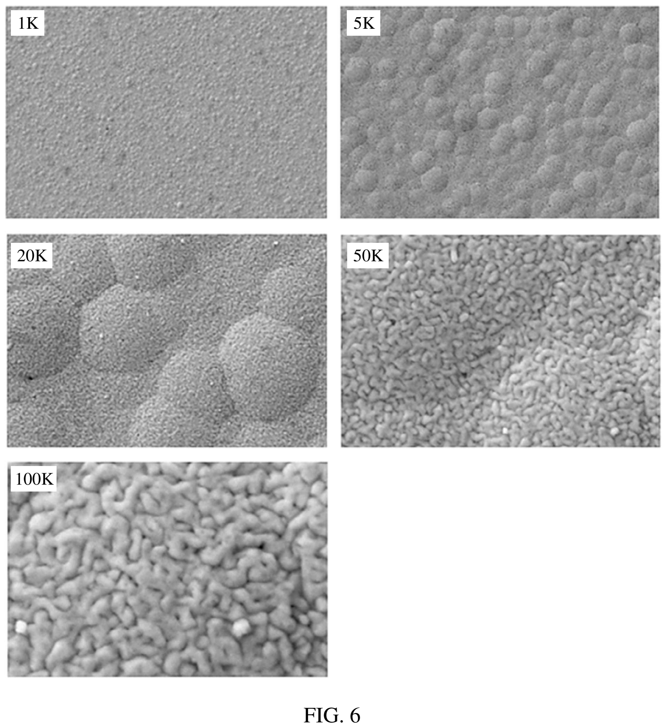

In Test Example 2, an SEM test is performed on surface morphology of the gold plating layer of the aluminum matrix composite material provided in Embodiment 1 and surface morphology of the gold plating layer of the aluminum matrix composite material provided in Comparative Example 2. For test results, refer to FIG. 5 and FIG. 6.

FIG. 5 shows an example of magnified morphology of the gold plating layer of the aluminum matrix composite material according to Embodiment 1 at different magnifications, where magnifications of a scanning electron microscope are 1K, 5K, 20K, 50K, and 100K.

FIG. 6 shows an example of magnified morphology of the gold plating layer of the aluminum matrix composite material according to Comparative Example 1 at different magnifications, where magnifications of a scanning electron microscope are 1K, 5K, 20K, 50K, and 100K.

It can be learned from FIG. 5 that, the gold plating layer of the aluminum matrix composite material provided in Embodiment 1 exhibits a flat and uniform surface, compact lattices, no spherical nodule or pore, and a small cell size (< 100 nm). As a result, the gold plating layer has high stability and can effectively resist oxidation and corrosion.

It can be learned from FIG. 6 that, the gold plating layer of the aluminum matrix composite material provided in Comparative Example 1 retains the surface morphology of the nickel plating layer, and exhibits poor film continuity and loose grain boundaries. As a result, the gold plating layer has poor stability and is susceptible to accelerated corrosion.

The foregoing descriptions are merely intended to help a person skilled in the art understand the technical solutions of the present disclosure, and are not intended to limit the present disclosure. Any modification, equivalent replacement, improvement, or the like made without departing from the spirit and principle of the present disclosure shall fall within the protection scope of the present disclosure.

## Claims

1. A preparation method for an aluminum matrix composite material, wherein the preparation method for the aluminum matrix composite material comprises:
performing purification processing on an aluminum-based substrate to obtain a purified aluminum-based substrate;
forming a metal protective layer on a surface of the purified aluminum-based substrate to obtain a first composite material intermediate;
performing first electroplating processing on the first composite material intermediate, so that the metal protective layer is corroded to form a first metal plating layer on the surface of the aluminum-based substrate and obtain a second composite material intermediate; and
performing second electroplating processing on the second composite material intermediate to form a second metal plating layer on a surface of the first metal plating layer and obtain the aluminum matrix composite material.

2. The preparation method for the aluminum matrix composite material according to claim 1, wherein the metal protective layer comprises a zinc layer.

3. The preparation method for the aluminum matrix composite material according to claim 2, wherein forming the metal protective layer on the surface of the purified aluminum-based substrate to obtain the first composite material intermediate comprises:
placing the purified aluminum-based substrate in a zinc plating solution and performing zinc plating processing, to form the zinc layer on the surface of the purified aluminum-based substrate and obtain the first composite material intermediate, wherein
the zinc plating solution comprises components in the following formulation:
50 g/L to 200 g/L of sodium hydroxide, 5 g/L to 50 g/L of potassium sodium tartrate, 1 g/L to 10 g/L of zinc oxide, 0.2 g/L to 2 g/L of iron and ferrous compounds, and water as balance, so that a pH value of the zinc plating solution ranges from 12 to 14.

4. The preparation method for the aluminum matrix composite material according to claim 1, wherein a thickness of the metal protective layer ranges from 1 nm to 100 nm.

5. The preparation method for the aluminum matrix composite material according to any one of claims 1 to 4, wherein the first metal plating layer comprises a nickel plating layer or a nickel-phosphorus alloy plating layer; and
the second metal plating layer comprises a gold plating layer.

6. The preparation method for the aluminum matrix composite material according to claim 5, wherein the first metal plating layer is a nickel plating layer, the first electroplating processing uses a nickel plating solution, and the nickel plating solution comprises components in the following formulation: 1 g/L to 50 g/L of nickel sulfate, 1 g/L to 50 g/L of nickel chloride, 1 g/L to 50 g/L of nickel methanesulfonate, 1 g/L to 50 g/L of hydrochloric acid, 1 g/L to 10 g/L of a primary brightener, 0.1 g/L to 1 g/L of an auxiliary brightener, and water as balance.

7. The preparation method for the aluminum matrix composite material according to claim 6, wherein during the first electroplating processing, a current density ranges from 0.1 ASD to 5 ASD, and an electroplating temperature ranges from 45°C to 65°C.

8. The preparation method for the aluminum matrix composite material according to claim 5, wherein the second metal plating layer is a gold plating layer, the second electroplating processing uses a gold plating solution, and the gold plating solution comprises components in the following formulation: 10 g/L to 20 g/L of gold trichloride, 50 g/L to 130 g/L of sodium sulfite, 30 g/L to 50 g/L of ethylenediaminetetraacetic acid, 30 g/L to 50 g/L of citric acid, 50 g/L to 80 g/L of potassium chloride, and water as balance.

9. The preparation method for the aluminum matrix composite material according to claim 8, wherein during the second electroplating processing, a current density ranges from 0.1 ASD to 5 ASD, and an electroplating temperature ranges from 30°C to 45°C.

10. The preparation method for the aluminum matrix composite material according to any one of claims 1 to 9, wherein the preparation method for the aluminum matrix composite material further comprises: before performing the zinc plating processing on the purified aluminum-based substrate, performing surface etching processing on the purified aluminum-based substrate, so that a rough structure is formed on the surface of the purified aluminum-based substrate, wherein
the rough structure is configured to enhance a bonding force between the aluminum-based substrate and the first metal plating layer.

11. The preparation method for the aluminum matrix composite material according to claim 10, wherein the purified aluminum-based substrate is placed in an etching solution to perform the surface etching processing; and
the etching solution comprises components in the following formulation:
10 g/L to 50 g/L of tetramethylammonium hydroxide, 10 g/L to 50 g/L of disodium ethylenediaminetetraacetate, 5 g/L to 20 g/L of zinc oxide, 5 g/L to 20 g/L of barbituric acid, 0.1 g/L to 1 g/L of a soluble silver salt, and water as balance, so that a pH value of the etching solution ranges from 10 to 13.

12. An aluminum matrix composite material, wherein the aluminum matrix composite material comprises an aluminum-based substrate, a first metal plating layer, and a second metal plating layer that are sequentially stacked;
a cell diameter of the first metal plating layer is less than or equal to 100 nm; and
a cell diameter of the second metal plating layer is less than or equal to 100 nm.

13. The aluminum matrix composite material according to claim 12, wherein a rough structure is provided on a surface that is of the aluminum-based substrate and on which the aluminum-based substrate and the first metal plating layer are bonded to each other, and the rough structure is configured to enhance a bonding force between the aluminum-based substrate and the first metal plating layer.

14. An electronic device, wherein the electronic device comprises a device body and a pad structure connected to the device body, and the pad structure is prepared by using the aluminum matrix composite material according to claim 12 or 13.

15. The electronic device according to claim 14, wherein the electronic device comprises a chip and a printed circuit board.
